# EUROPEAN PATENT APPLICATION

(11) **EP 1 811 574 A2**
(43) Date of publication of application: **25.07.2007**
(21) Application number: 07250222.2
(22) Date of filing: 19.01.2007
(51) Int. Cl.: H01L 31/04, H01L 31/042, H01L 31/18

(54) **Photovoltaic element, photovoltaic module comprising photovoltaic element, and method of fabricating photovoltaic element**

(30) Priority: 20.01.2006 JP 2006011952
(71) Applicant: SANYO ELECTRIC CO., LTD., Moriguchi-shi, Osaka 570-8677 (JP)
(72) Inventor: Nakashima, Takeshi, Kobe-shi Hyogo 655-0006 (JP); Maruyama, Eiji, Katano-shi Osaka 576-0021 (JP)
(74) Representative: Calderbank, Thomas Roger

(57) **Abstract**

A photovoltaic element comprising a transparent conductive film (1b) capable of improving weather resistance is obtained. This photovoltaic element includes a photoelectric conversion layer (1a), and a transparent conductive film (1b) formed on a surface of the photoelectric conversion layer (1a) and including an indium oxide layer having (222) orientation and two X-ray diffraction peaks, in which the two X-ray diffraction peaks of the indium oxide layer is constituted by a first peak on a low angle side and a second peak on a high angle side having a peak intensity level lower than the first peak.

## Description

The present invention relates to a photovoltaic element, a photovoltaic module comprising the photovoltaic element, and a method of fabricating the photovoltaic element, and more particularly, it relates to a photovoltaic element comprising a transparent conductive film including an indium oxide layer, a photovoltaic module comprising the photovoltaic element, and a method of fabricating the photovoltaic element.

A photovoltaic element comprising a transparent conductive film including an indium oxide layer is disclosed in Japanese Patent Laying-Open No. 2004-281586. There is disclosed the photovoltaic device (photovoltaic element) comprising a photoelectric conversion layer and the transparent conductive film formed on a surface of the photoelectric conversion layer and consisting of an indium tin oxide (ITO) layer having two X-ray diffraction peaks. In the photovoltaic device, the two X-ray diffraction peaks of the indium tin oxide layer include a peak on a low angle side and a peak on a high angle side having an intensity level higher than the peak on the low angle side.

In the photovoltaic device disclosed in Japanese Patent Laying-Open No. 2004-281586, the transparent conductive film is so formed that the indium tin oxide layer has the two X-ray diffraction peaks of the peak on the low angle side and the peak on the high angle side having the intensity level higher than the peak on the low angle side, whereby the resistance of the transparent conductive film can be reduced as compared with a case where the indium oxide layer has only one X-ray diffraction peak. In addition, the transparent conductive film is formed in the aforementioned manner, light absorption loss of the transparent conductive film can be reduced as compared with the case where the indium oxide layer has only one X-ray diffraction peak. In the photovoltaic device (photovoltaic element), it is known that the transparent conductive film having low resistance and low light absorption loss is effective in increasing the cell output (Pmax) of the photovoltaic element. In the photovoltaic device disclosed in Japanese Patent Laying-Open No. 2004-281586, the resistance and the light absorption loss of the transparent conductive film can be reduced as compared with the case where the indium oxide layer has only one X-ray diffraction peak, whereby the cell output (Pmax) of the photovoltaic device can be increased.

In the photovoltaic device disclosed in Japanese Patent Laying-Open No. 2004-281586, however, sufficient studies on weather resistance have not been made. Thus, it is disadvantageously difficult to improve the weather resistance.

The present invention has been proposed in the light of

the aforementioned problem, and an object of the present invention is to provide a photovoltaic element comprising a transparent conductive film which may improve weather resistance, a photovoltaic module comprising the photovoltaic element, and a method of fabricating the photovoltaic element.

In order to attain the aforementioned object, a photovoltaic element according to a first aspect of the present invention comprises a photoelectric conversion layer and a transparent conductive film formed on a surface of the photoelectric conversion layer and including an indium oxide layer having (222) orientation and two X-ray diffraction peaks, wherein the two X-ray diffraction peaks of the indium oxide layer are constituted by a first peak on a low angle side and a second peak on a high angle side having a peak intensity level lower than the first peak.

In the photovoltaic element according to the first aspect, as hereinabove described, the transparent conductive film including the indium oxide layer having (222) orientation and the two X-ray diffraction peaks is provided, in which the two X-ray diffraction peaks of the indium oxide layer are constituted by the first peak on the low angle side and the second peak on the high angle side having the peak intensity level lower than the first peak, whereby weather resistance can be improved as compared with a case where the indium oxide layer has the two X-ray diffraction peaks of the peak on the low angle side and the peak on the high angle side having the peak intensity level higher than the peak on the low angle side. As a result, it is possible to obtain the photovoltaic element comprising the transparent conductive film capable of further increasing a cell output (Pmax) after a lapse of a long time while improving weather resistance. The aforementioned effect has been confirmed by experiments described later.

In the aforementioned photovoltaic element according to the first aspect, the first peak on the low angle side of the indium oxide layer preferably has an angle 2θ (θ:X-ray diffraction angle) in the vicinity of 30.1 degrees, and the second peak on the high angle side of the indium oxide layer preferably has an angle 2θ (θ : X-ray diffraction angle) in the vicinity of 30.6 degrees. In a case where the angles 2θ of the first peak and the second peak are in the vicinity of 30.1 degrees and 30.6 degrees, respectively, and the first peak on the low angle side has the peak intensity level higher than the second peak on the high angle side, weather resistance can be improved.

In the aforementioned photovoltaic element according to the first aspect, the intensity ratio between the first peak and the second peak of the indium oxide layer is preferably at least 1. According to this structure, weather resistance can be improved as compared with a case where the intensity ratio between the first peak and the second peak of the indium oxide layer is less than 1. This effect has also been confirmed by the experiments described later.

In this case, the intensity ratio between the first peak and the second peak of the indium oxide layer is preferably at most 2. According to this structure, a cell output (Pmax) can be increased. This effect has also been confirmed by the experiments described later.

In the aforementioned photovoltaic element according to the first aspect, the indium oxide layer preferably includes W. According to this structure, in the photovoltaic device comprising the transparent conductive film consisting of the indium oxide layer including W (IWO layer), weather resistance can be improved.

In the aforementioned photovoltaic element according to the first aspect, the indium oxide layer preferably includes Sn. According to this structure, in the photovoltaic device comprising the transparent conductive film consisting of the indium oxide layer including Sn (ITO layer), weather resistance can be improved.

The aforementioned photovoltaic element according to the first aspect may further comprise a semiconductor layer formed thereon with the transparent conductive film and consisting of at least either an amorphous semiconductor or a microcrystalline semiconductor and a collector formed on the transparent conductive film.

In this case, the semiconductor layer may include an amorphous silicon layer.

A photovoltaic module according to a second aspect of the present invention comprises a photoelectric conversion layer, a plurality of photovoltaic elements, each of which including a transparent conductive film formed on a surface of the photoelectric conversion layer and including an indium oxide layer having (222) orientation and two X-ray diffraction peaks, a transparent surface protector arranged on surfaces of the transparent conductive films of the plurality of photovoltaic elements, and a resin film so arranged as to hold the plurality of photovoltaic elements between the surface protector and the resin film, wherein the two X-ray diffraction peaks of the indium oxide layer of the photovoltaic element are constituted by a first peak on a low angle side and a second peak on a high angle side having a peak intensity level lower than the first peak.

In the photovoltaic module according to the second aspect, as hereinabove described, the plurality of photovoltaic elements, each of which including the transparent conductive film including the indium oxide layer having (222) orientation and the two X-ray diffraction peaks, are provided, in which the two X-ray diffraction peaks of the indium oxide layer are constituted by the first peak on the low angle side and the second peak on the high angle side having the peak intensity level lower than the first peak, whereby weather resistance can be improved as compared with a case where the indium oxide layer has the two X-ray diffraction peaks of the peak on the low angle side and the peak on the high angle side having the peak intensity level higher than the peak on the low angle side. As a result, it is possible to obtain the photovoltaic module comprising the transparent conductive films capable of further increasing a cell output (Pmax) after a lapse of a long time while improving weather resistance.

In the aforementioned photovoltaic module according to the second aspect, the first peak on the low angle side of the indium oxide layer preferably has an angle 2θ (θ:X-ray diffraction angle) in the vicinity of 30.1 degrees, and the second peak on the high angle side of the indium oxide layer preferably has an angle 2θ (θ: X-ray diffraction angle) in the vicinity of 30.6 degrees. In a case where the angles 2θ of the first peak and the second peak are in the vicinity of 30.1 degrees and 30.6 degrees, respectively, and the first peak on the low angle side has the peak intensity level higher than the second peak on the high angle side, weather resistance can be improved.

In the aforementioned photovoltaic module according to the second aspect, the intensity ratio between the first peak and the second peak of the indium oxide layer is preferably at least 1. According to this structure, weather resistance can be improved as compared with a case where the intensity ratio between the first peak and the second peak of the indium oxide layer is less than 1. This effect has also been confirmed by the experiments described later.

In this case, the intensity ratio between the first peak and the second peak of the indium oxide layer is preferably at most 2. According to this structure, a cell output (Pmax) can be increased. This effect has also been confirmed by the experiments described later.

In the aforementioned photovoltaic module according to the second aspect, the indium oxide layer preferably includes W. According to this structure, in the photovoltaic device comprising the transparent conductive film consisting of the indium oxide layer including W (IWO layer), weather resistance can be improved.

In the aforementioned photovoltaic module according to the second aspect, the indium oxide layer preferably includes Sn. According to this structure, in the photovoltaic device comprising the transparent conductive film consisting of the indium oxide layer including Sn (ITO layer), weather resistance can be improved.

The aforementioned photovoltaic module according to the second aspect may further comprise a semiconductor layer formed thereon with the transparent conductive film and consisting of at least either an amorphous semiconductor or a microcrystalline semiconductor, and a collector formed on the transparent conductive film.

In this case, the semiconductor layer may include an amorphous silicon layer.

A method of fabricating a photovoltaic element according to a third aspect of the present invention comprises steps of forming a photoelectric conversion layer, and forming a transparent conductive film including an indium oxide layer having (222) orientation and two X-ray diffraction peaks on a surface of the photoelectric conversion layer by ion plating, wherein the two X-ray diffraction peaks of the indium oxide layer are constituted by a first peak on a low angle side and a second peak on a high angle side having a peak intensity level lower than the first peak.

The method of fabricating a photovoltaic element according to the third aspect, as hereinabove described, the transparent conductive film including the indium oxide layer having (222) orientation and the two X-ray diffraction peaks is formed, in which the two X-ray diffraction peaks of the indium oxide layer are constituted by the first peak on the low angle side and the second peak on the high angle side having the peak intensity level lower than the first peak. Thus, weather resistance can be improved as compared with a case where the indium oxide layer has the two X-ray diffraction peaks of the peak on the low angle side and the peak on the high angle side having the peak intensity level higher than the first peak. As a result, it is possible to fabricate the photovoltaic element comprising the transparent conductive film capable of further increasing a cell output (Pmax) after a lapse of a long time while improving weather resistance.

In the method of fabricating a photovoltaic element according to the third aspect, the step of forming the transparent conductive film preferably includes a step of forming the transparent conductive film by ion plating under a condition of an ion energy of at least 10 eV and not more than 20 eV. According to this structure, damage to the photoelectric conversion layer due to ions can be reduced. Thus, it is possible to suppress reduction in weather resistance caused by damage to the photoelectric conversion layer due to ions.

In the method of fabricating a photovoltaic element according to the third aspect, the step of forming the transparent conductive film preferably includes a step of forming the transparent conductive film by ion plating under a condition where the content of WO₃ powder in a In₂O₃ target is at least 1 percent by weight and not more than 3 percent by weight and a pressure of a gas mixture of Ar and O₂ is at least 0.7 Pa and not more than 1.0 Pa. According to this structure, the two X-ray diffraction peaks of the indium oxide layer can be easily constituted by the first peak on the low angle side and the second peak on the high angle side having the peak intensity level lower than the first peak, and the intensity ratio between the first peak and the second peak of the indium oxide layer can be at least 1 and not more than 2.

In the method of fabricating a photovoltaic element according to the third aspect, the step of forming the transparent conductive film preferably includes a step of forming the transparent conductive film prepared from a In₂O₃ target containing SnO₂ powder by ion plating under a condition where a pressure of a gas mixture of Ar and O₂ is at least 0.4 Pa and not more than 1.0 Pa. According to this structure, the two X-ray diffraction peaks of the indium oxide layer can be easily constituted by the first peak on the low angle side and the second peak on the high angle side having the peak intensity level lower than the first peak, and the intensity ratio between the first peak and the second peak of the indium oxide layer can be at least 1 and not more than 2.

The foregoing and other objects, features, aspects and advantages of the present invention will become more apparent from the following detailed description of the present invention when taken in conjunction with the accompanying drawings.

### IN THE DRAWINGS

Fig. 1 is a sectional view showing a structure of a photovoltaic module comprising a photovoltaic element according to an embodiment of the present invention;
Fig. 2 is a diagram for illustrating the relation between pressures of a gas mixture of Ar and O₂ and X-ray diffraction spectra of transparent conductive films;
Fig. 3 is a diagram for illustrating the relation between pressures of a gas mixture of Ar and O₂ and normalized cell outputs (Pmax) of photovoltaic elements;
Fig. 4 is a diagram for illustrating the relation between pressures of a gas mixture of Ar and O₂, the contents of WO₃ in In₂O₃ targets, and intensity ratios (P1/P2) between first peaks (P1) and second peaks (P2) of the transparent conductive films;
Fig. 5 is a diagram illustrating the relation between intensity ratios (P1/P2) of first peaks (P1) and second peaks (P2) of transparent conductive films and normalized weather resistance of photovoltaic elements.
Fig. 6 is a diagram for illustrating the relation between pressures of a mixed gas of Ar and O₂, the contents of WO₃ in In₂O₃ targets, and normalized cell outputs (Pmax) of photovoltaic elements.

An embodiment of the present invention will be hereinafter described with reference to the drawings.

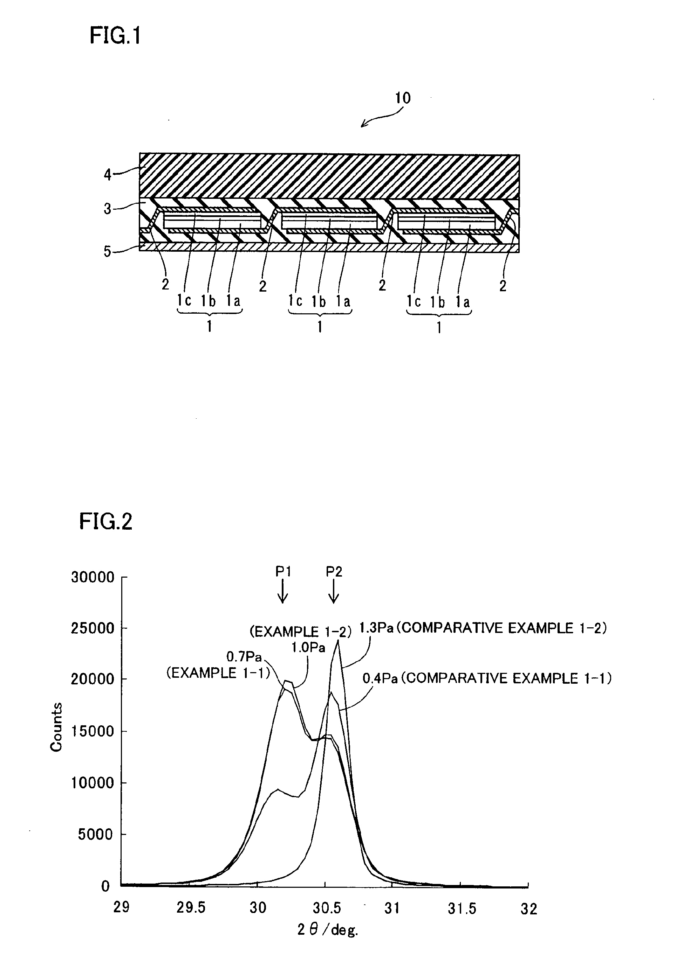

First, a structure of photovoltaic elements 1 according to the embodiment of the present invention will be described. Each photovoltaic element 1 according to the embodiment of the present invention is formed with a transparent conductive film 1b on an upper surface of a semiconductor 1a including a photoelectric conversion layer as shown in Fig. 1. A collector 1c is formed on an upper surface of the transparent conductive film 1b. The semiconductor 1a including the photoelectric conversion layer is constituted by an n-type (100) single-crystalline silicon substrate (photoelectric conversion layer) (hereinafter referred to as "n-type single-crystalline silicon substrate") having resistivity of about 1 Ω·cm and a thickness of about 200 µm, a substantially intrinsic i-type amorphous silicon layer having a thickness of about 5 nm, formed on an upper surface of the n-type single-crystalline silicon substrate, and a p-type amorphous silicon layer having a thickness of about 5 nm, formed on the i-type amorphous silicon layer. Each transparent conductive film 1b consisting of an indium oxide layer having a thickness of about 100nm is formed on the p-type amorphous silicon layer.

According to this embodiment, the transparent conductive film 1b is formed by the indium oxide layer having (222) orientation and two X-ray diffraction peaks.

According to this embodiment, the two X-ray diffraction peaks of the transparent conductive film 1b are constituted by a first peak (P1) on a low angle side having an angle 2θ (θ: X-ray diffraction angle) of 30.1 ± 0.1 degrees and a second peak (P2) on a high angle side having a peak intensity level lower than the peak intensity level of the first peak (P1) and having an angle 2θ (θ:X-ray diffraction angle) of 30.6 ± 0.1 degrees. The intensity ratio (P1/P2) between the first peak (P1) and the second peak (P2) is at least 1 and and not more than 2.

A collector 1c of silver (Ag) having a thickness of about 10 µm to about 30 µm is formed on a prescribed region of the upper surface of the transparent conductive film 1b. This collector 1c is constituted by a plurality of finger electrode parts so formed as to extend in parallel with each other at a prescribed interval and a bus bar electrode part aggregating currents flowing in the finger electrode parts. A back electrode of silver (Ag) having a thickness of about 10 µm to about 30 µm is formed on a back surface of the n-type single-crystalline silicon substrate. The back electrode is constituted by a plurality of finger electrode parts so formed as to extend in parallel with each other at a prescribed interval and a bus bar electrode part aggregating currents flowing in the finger electrode parts.

With reference to Fig. 1, a structure of a photovoltaic module 10 comprising the photovoltaic elements 1 according to the embodiment of the present invention will be now described. The photovoltaic module 10 according to the embodiment of the present invention comprises the plurality of photovoltaic elements 1 having the aforementioned structure, and each of these plurality of photovoltaic element 1 is connected to another photovoltaic elements 1 adjacent thereto through a tab electrode 2 folded in a stepped configuration. The photovoltaic elements 1 connected with each other through the tab electrodes 2 are sealed with a filler 3 consisting of EVA (Ethylene Vinyl Acetate) resin. A surface protector 4 consisting of glass for surface protection is arranged on an upper surface (light receiving surface side) of the filler 3 sealing the plurality of photovoltaic elements 1. A resin film 5 such as PVF (Poly Vinyl Fluoride) film is arranged on a lower surface of the filler 3 sealing the plurality of photovoltaic elements 1.

A process of fabricating the photovoltaic element 1 according to the embodiment of the present invention will be now described. First, the n-type single-crystalline silicon substrate having resistivity of about 1 Ω·cm and a thickness of about 300 µm is cleaned, thereby removing impurities to form a texture structure (irregular configuration) by etching or the like. The i-type amorphous silicon layer and the p-type amorphous silicon layer are successively deposited on the n-type single-crystalline silicon substrate with thicknesses of about 5 nm respectively by RF plasma CVD under a condition of a frequency of about 13.56 MHz, a formation temperature of about 100°C to about 300°C, a reaction pressure of about 5 Pa to about 100 Pa, and RF power of about 1 mW/cm² to about 500 mW/cm², thereby forming a p-i-n junction. A group III element such as B, Al, Ga or In can be employed as a p-type dopant for forming the p-type amorphous silicon layer. The p-type amorphous silicon layer can be formed by mixing compound gas containing at least one of the aforementioned p-type dopants into material gas such as SiH₄ (silane) gas at a time of forming the p-type amorphous silicon layer.

According to this embodiment, the transparent conductive film consisting of the indium oxide film having a thickness of about 100nm is formed on the p-type amorphous silicon layer by ion plating. More specifically, a target consisting of a sintered body of In₂O₃ powder containing about 1 percent by weight to about 5 percent by weight of WO₃ powder or SnO₂ powder for doping is set on a position facing a substrate in a chamber (not shown). In this case, the W content or the Sn content in the indium oxide film can be varied by changing a quantity of the WO₃ powder or the SnO₂ powder. According to this embodiment, the transparent conductive film consisting of the indium oxide film is formed on the p-type amorphous silicon layer by ion plating, whereby an ion energy in forming the transparent conductive film on the p-type amorphous silicon layer can be reduced to about 10 eV to about 20 eV. Accordingly, the ion energy can be considerably reduced, as compared with a case where the ion energy is 100 eV or more as in a case of forming the transparent conductive film by usual sputtering, for example. Thus, it is possible to reduce damages to the p-type amorphous silicon layer, the i-type amorphous silicon layer and the n-type single-crystalline silicon substrate.

The chamber (not shown) is evacuated in a state of oppositely arranging the n-type single-crystalline silicon substrate formed with the p-type amorphous silicon layer in parallel with the target. Thereafter a gas mixture of Ar and O₂ is fed for holding the pressure at about 0.4 Pa to about 1.0 Pa, thereby starting discharge. A partial pressure of Ar gas is maintained at about 0.36 Pa. In this case, a film forming rate is about 10 nm/min. to about 80 nm/min in a state where the n-type single-crystalline silicon substrate is stood still with respect to the target. The transparent conductive film consisting of the indium oxide film is formed with the thickness of about 100 nm in the aforementioned manner, and the discharge is thereafter stopped.

Then, Ag paste prepared by kneading impalpable silver (Ag) powder into epoxy resin is applied to the prescribed region of the upper surface of the transparent conductive film by screen printing to have a thickness of about 10 µm to about 30 µm and a width of about 100 µm to about 500 µm and thereafter fired at about 200°C for about 80 minutes to be hardened, thereby forming the collector consisting of the plurality of finger electrode parts formed to extend in parallel with each other at the prescribed interval and the bus bar electrode part aggregating the currents flowing in the finger electrode parts. After that, Ag paste prepared by kneading impalpable silver (Ag) powder into epoxy resin is applied to the lower surface of the n-type single-crystalline silicon substrate by screen printing to have a thickness of about 10 µm to about 30 µm and thereafter fired at about 200°C for about 80 minutes to be hardened, thereby forming the back electrode consisting of the plurality of finger electrode parts formed to extend in parallel with each other at the prescribed interval and the bus bar electrode part aggregating the currents flowing in the finger electrode parts. Thus, the photovoltaic element 1 according to this embodiment is formed in the aforementioned manner.

With reference to Fig. 1, a process of fabricating the photovoltaic module 10 comprising the photovoltaic elements 1 according to the embodiment of the present invention will be now described. As shown in Fig. 1, a first end of the tab electrode 2 of copper foil is connected to the bus bar electrode part of the collector of each of the plurality of photovoltaic elements 1 formed in the aforementioned manner. A second end of the tab electrode 2 is connected to the bus bar electrode part (not shown) of the back electrode of adjacent photovoltaic element 1. Thus, the plurality of photovoltaic elements 1 are connected in series as shown in Fig. 1.

Then, an EVA sheet for forming the filler 3, the plurality of photovoltaic elements 1 connected by the tab electrodes 2, and the EVA sheet for forming the filler 3 are arranged between the surface protector 4 of glass and a resin film 5 in order from a side of the surface protector 4, and thereafter a vacuum laminating process is performed while heating. Thus, the photovoltaic module 10 according to this embodiment shown in Fig. 1 is formed.

According to this embodiment, as hereinabove described, the transparent conductive film including the indium oxide film having (222) orientation and the two X-ray diffraction peaks is provided, in which the two X-ray diffraction peaks of the indium oxide film is constituted by the first peak on the low angle side and the second peak on the high angle side having the peak intensity level lower than the first peak, whereby weather resistance can be improved as compared with a case where the indium oxide film has the two X-ray diffraction peaks of the peak on the low angle side and the peak on the high angle side having the peak intensity level higher than the peak on the low angle side. As a result, it is possible to obtain the photovoltaic element 1 comprising the transparent conductive film capable of further increasing the cell output (Pmax) after a lapse of a long time while improving weather resistance.

Figs. 2 to 6 are diagrams for illustrating experiments made for confirming effects of the photovoltaic elements according to this embodiment shown in Fig. 1 and the photovoltaic module comprising the photovoltaic elements. The experiments made for confirming the effects of the photovoltaic elements 1 according to this embodiment and the photovoltaic module 10 comprising the photovoltaic elements 1 will be now described with reference to Figs. 2 to 6.

With reference to Fig. 2, a description will be made of an experiment for evaluation of the relation between pressures of a gas mixture of Ar and O₂ and X-ray diffraction spectra of transparent conductive films. In this experiment, samples according to Examples 1-1 and 1-2 corresponding to this embodiment and samples according to comparative examples 1-1 and 1-2 are prepared, and X-ray diffraction spectra of the transparent conductive films are measured as to the prepared samples.

As the sample according to Example 1-1, a target consisting of a sintered body of In₂O₃ powder containing about 1 percent by weight of WO₃ powder was employed for preparing a photovoltaic element 1 formed on a p-type amorphous silicon layer with a transparent conductive film (IWO film) of about 100 nm in thickness by ion plating. At this time, the pressure of a gas mixture of Ar and O₂ was about 0.7 Pa, the partial pressure of Ar gas in the gas mixture was about 0.36 Pa. In order to excellently detect a signal of the X-ray diffraction spectrum, an n-type single-crystalline silicon substrate having a relatively flat front surface was employed. In the sample according to Example 1-1, a collector and a back electrode were not formed, and heat treatment was carried out at about 200°C for about 80 minutes in consideration of heat treatment in forming the collector and the back electrode. The remaining structures of this sample according to Example 1-1 and a process of fabricating the same were similar to those of the photovoltaic device 1 according to the aforementioned embodiment. In a sample according to Example 1-2, a transparent conductive film was formed at a pressure of a gas mixture of Ar and O₂ of about 1.0 Pa and a partial pressure of Ar gas in the gas mixture of about 0.36 Pa. In a sample according to comparative example 1-1, a transparent conductive film was formed at a pressure of a gas mixture of Ar and O₂ of about 0.4 Pa and a partial pressure of Ar gas in the gas mixture of about 0.36 Pa. In a sample according to comparative example 1-2, a transparent conductive film was formed at a pressure of a gas mixture of Ar and O₂ of about 1.3 Pa and a partial pressure of Ar gas in the gas mixture of about 0.36 Pa. Conditions other than the aforementioned conditions for preparing the samples according to Example 1-2 and comparative examples 1-1 and 1-2 were similar to those of the sample according to Example 1-1. Partial pressures of Ar gas in Examples 1-1 and 1-2 and comparative examples 1-1 and 1-2 (about 0.36 Pa) were the same. From this, it is shown that when the pressure of the gas mixture of Ar and O₂ is large, the content of oxygen (O₂) in the gas mixture is increased. X-ray diffraction spectra were measured as to these samples with an X-ray analyzer. Results thereof are shown in Fig. 2.

As shown in Fig. 2, it has been proved that the X-ray diffraction peak of the transparent conductive film can be controlled by controlling the pressure of the gas mixture of Ar and O₂. More specifically, the samples according to the Examples 1-1 and 1-2, in which the transparent conductive films were formed at pressures of a gas mixture of Ar and O₂ of about 0.7 Pa and about 1.0 Pa respectively, have two peaks of a first peak (P1) on a low angle side having an angle 2θ (θ:X-ray diffraction angle) of 30.1 ± 0.1 degrees and a second peak (P2) on a high angle side having a peak intensity level lower than the first peak (P1) and an angle 2θ (θ: X-ray diffraction angle) of 30.6 ± 0.1 degrees. The sample according to comparative example 1-1, in which the transparent conductive film was formed at a pressure of a gas mixture of Ar and O₂ of about 0.4 Pa, has two peaks of a first peak (P1) on a low angle having an angle 2θ (θ:X-ray diffraction angle) of 30.1 ± 0.1 degrees and a second peak (P2) on a high angle side having a peak intensity level higher than the first peak (P1) and an angle 2θ (θ : X-ray diffraction angle) of 30.6 ± 0.1 degrees. The sample according to comparative example 1-2, in which the transparent conductive film was formed at a pressure of a gas mixture of Ar and O₂ of about 1.3 Pa has only a peak with an angle 2θ (θ: X-ray diffraction angle) of 30.6 ± 0.1 degrees. The specific resistances of the transparent conductive films of Examples 1-1 and 1-2 and comparative examples 1-1 and 1-2 were about 3 x 10⁻⁴ (Ω·cm) to about 9 x 10⁻⁴ (Ω·cm) (not shown). The specific resistance of comparative example 1-2, in which the transparent conductive film was formed at a pressure of a gas mixture of Ar and O₂ of about 1.3 Pa, was smallest, and it has been shown that increase in the pressure of a gas mixture of Ar and O₂ tends to reduce the specific resistance of the transparent conductive film.

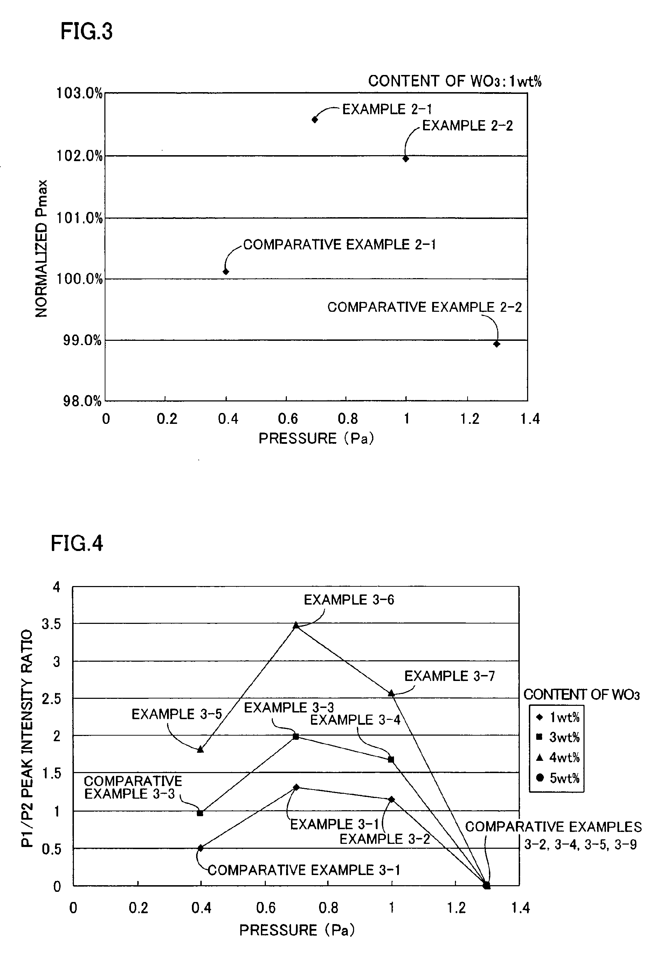

With reference to Fig. 3, results of evaluation of the relation between pressures of a gas mixture of Ar and O₂ and normalized cell outputs (Pmax) of the photovoltaic elements 1 will be described. In this experiment, samples according to Examples 2-1 and 2-2 corresponding to this embodiment and samples according to comparative examples 2-1 and 2-2 were prepared and normalized cell outputs (Pmax) were measured as to the prepared samples.

In the samples according to Example 2-1, Example 2-2, comparative example 2-1 and comparative example 2-2, an n-type single-crystalline silicon substrate with a front surface formed thereon with a texture structure (irregular configuration) was employed, and a collector and a back electrode were formed on a transparent conductive film (IWO film) formed on an upper of the p-type amorphous silicon layer and a lower surface of an n-type single-crystalline silicon substrate, respectively, dissimilarly to the samples according to the aforementioned Example 1-1, Example 1-2, comparative example 1-1 and comparative example 1-2. The remaining structures of the samples according to Example 2-1, Example 2-2, comparative example 2-1 and comparative example 2-2 and processes of fabricating the IWO films were similar to those of the samples according to the aforementioned Example 1-1, Example 1-2, comparative example 1-1 and comparative example 1-2, respectively. More specifically, a pressure of a gas mixture of Ar and O₂ was about 0.7Pa in Example 2-1, while a pressure of a gas mixture of Ar and O₂ was about 1.0 Pa in Example 2-2. A pressure of a gas mixture of Ar and O₂ was about 0.4 Pa in comparative example 2-1, a pressure of a gas mixture of Ar and O₂ was about 1.3 Pa in comparative example 2-2. Thus, in Examples 2-1 and 2-2, second peaks (P2) on high angle side having peak intensity levels lower than the first peaks (P1) on the low angle side were obtained similarly to Examples 1-1 and 1-2 shown in Fig. 2, respectively. In comparative example 2-1, a second peak (P2) on a high angle side having a peak intensity level higher than a first peak (P1) on a low angle side was obtained similarly to comparative example 1-1 shown in Fig. 2. In comparative example 2-2, only one peak (P2) was obtained similarly to comparative example 1-2 shown in Fig. 2. Cell outputs (Pmax) were measured as to these samples according to Example 2-1, Example 2-2, comparative example 2-1 and comparative example 2-2, and the cell outputs (Pmax) were normalized. Results of these are shown in Fig. 3.

The cell outputs (Pmax) were normalized based on the cell outputs by a normalized photovoltaic element comprising a transparent conductive film consisting of an ITO film having two peaks of a first peak (P1) on a low angle side of an angle 2θ (θ: X-ray diffraction angle) of 30.1 ± 0.1 degrees and a second peak (P2) on a high angle side having a peak intensity level higher than the first peak (P1) and an angle 2θ (θ: X-ray diffraction angle) of 30.6 ± 0.1 degrees. In the normalized photovoltaic element, a target consisting of a sintered body of In₂O₃ powder containing about 5 percent by weight of SnO₂ powder was employed by DC sputtering for forming a transparent conductive film. Forming conditions of the transparent conductive film (ITO film) by DC sputtering were a substrate temperature of 60°C, an Ar flow rate of 200 sccm, a pressure of 0.5 Pa, DC power of 1 kW and a magnetic field of 2000 G applied to a cathode. The remaining structures of the normalized photovoltaic element and a process of fabricating the same are similar to those of the photovoltaic element 1 according to the aforementioned embodiment.

As shown in Fig. 3, it has been proved that the cell outputs (Pmax) are increased in the samples according to Examples 2-1 and 2-2, each of which including the transparent conductive film consisting of an IWO film and having the second peak (P2) on the high angle side with the peak intensity level lower than the first peak (P1) on the low angle side, as compared with the sample according to comparative example 2-1 having the second peak (P2) on the high angle side with the peak intensity level higher than the first peak (P1) on the low angle side and the sample according to comparative example 2-2 having only one peak (P2). More specifically, in samples according to Examples 2-1 and 2-2, each of which having the second peak (P2) on the high angle side with the peak intensity level lower than the first peak (P1) on the low angle side, the normalized cell outputs (Pmax) were about 102.7 % and about 101.9 %, respectively. On the other hand, in the sample according to comparative example 2-1 having the second peak (P2) on the high angle side with the peak intensity level higher than the first peak (P1) on the low angle side, the normalized cell outputs (Pmax) was about 100.1 %. In the sample according to comparative example 2-2 having only one peak, the normalized cell outputs (Pmax) was about 98.9 %. The reason that the normalized cell outputs (Pmax) of the sample according to comparative example 2-2 was less than 100 % is conceivably that the sample according to comparative example 2-2 has only one peak, while the normalized photovoltaic element has two peaks.

With reference to Fig. 4, results of evaluation of the relation between pressures of a gas mixture of Ar and O₂, the contents of WO₃ in In₂O₃ targets, intensity ratios (P1/P2) between first peaks (P1) and second peaks (P2) of transparent conductive films will be described. In this experiment, samples according to Examples 3-1 to 3-7 corresponding to this embodiment and samples according to comparative examples 3-1 to 3-9 were prepared, X-ray diffraction spectra of the transparent conductive films were measured as to the prepared sample, and the intensity ratios (P1/P2) between the first peaks (P1) and the second peaks (P2) of the transparent conductive films were calculated.

As the sample according to Example 3-1, a target consisting of a sintered body of In₂O₃ powder containing about 1 percent by weight of WO₃ powder was employed for preparing a photovoltaic element 1 formed on a p-type amorphous silicon layer with a transparent conductive film (IWO film) of about 100 nm in thickness by ion plating. At this time, a pressure of a gas mixture of Ar and O₂ was about 0.7 Pa, a partial pressure of Ar gas in the gas mixture was about 0.36 Pa. In order to excellently detect a signal of the X-ray diffraction spectrum, an n-type single-crystalline silicon substrate having a relatively flat front surface was employed. In the sample according to Example 3-1, a collector and a back electrode were not formed, and heat treatment was carried out at about 200°C for about 80 minutes in consideration of heat treatment in forming the collector and the back electrode. The remaining structures of the photovoltaic element 1 and a process of fabricating the same were similar to those of the photovoltaic element 1 according to the aforementioned embodiment. The samples according to Examples 3-2, 3-3, 3-4, 3-5, 3-6 and 3-7 were prepared from In₂O₃ targets having the contents of WO₃ powder of about 1 percent by weight, about 3 percent by weight, about 3 percent by weight, about 4 percent by weight, about 4 percent by weight and about 4 percent by weight, respectively. The samples according to Examples 3-2, 3-3, 3-4, 3-5, 3-6 and 3-7 were prepared at pressures of a gas mixture of Ar and O₂ of about 1.0 Pa, about 0.7 Pa, about 1.0 Pa, about 0.4 Pa, about 0.7 Pa and about 1.0 Pa, and partial pressures of Ar gas in the gas mixture of about 0.36 Pa, respectively. The samples according to comparative examples 3-1, 3-2, 3-3, 3-4, 3-5, 3-6, 3-7, 3-8 and 3-9 were prepared from targets having the contents of WO₃ powder of about 1 percent by weight, about 1 percent by weight, about 3 percent by weight, about 3 percent by weight, about 4 percent by weight, about 5 percent by weight, about 5 percent by weight, about 5 percent by weight and about 5 percent by weight, respectively. The samples according to comparative examples 3-1, 3-2, 3-3, 3-4, 3-5, 3-6, 3-7, 3-8 and 3-9 were prepared at pressures of a gas mixture of Ar and O₂ of about 0.4 Pa, about 1.3 Pa, about 0.4 Pa, about 1.3 Pa, about 1.3 Pa, about 0.4 Pa, about 0.7 Pa about 1.0 Pa and about 1.3 Pa and partial pressures of Ar gas in the gas mixture of about 0.36 Pa, respectively. Conditions other than the aforementioned conditions for preparing the samples according to Examples 3-2 to 3-7 and comparative examples 3-1 to 3-9 were similar to those of the sample according to Example 3-1. X-ray diffraction spectra were measured as to these samples of Examples 3-1 to 3-7 and comparative examples 3-1 to 3-7 with an X-ray analyzer, and the intensity ratios (P1/P2) between the first peaks (P1) and the second peaks (P2) of the transparent conductive films were measured. Results thereof are shown in Fig. 4.

As shown in Fig. 4, it has been proved that, when the content of WO₃ in the In₂O₃ target is in a range of about 1 percent by weight to about 4 percent by weight, as the content of WO₃ is increased, the intensity ratio (P1/P2) between the first peak (P1) and the second peak (P2) of the transparent conductive film is increased. In a case where pressures of a gas mixture of Ar and O₂ are set to about 0.7 Pa and about 1.0 Pa, the first peaks (P1) of the transparent conductive films became larger than the second peaks (P2) in the samples (Examples 3-1, 3-2, 3-3, 3-4, 3-6 and 3-7) having the contents of WO₃ powder of about 1 percent by weight to about 4 percent by weight. In the samples according to comparative examples 3-6 to 3-8 prepared from In₂O₃ targets having the contents of WO₃ powder of about 5 percent by weight, the peak intensity levels of the second peaks (P2) are not seen and only first peaks (P1) are seen. Therefore, the intensity ratios (P1/P2) between the first peaks (P1) and the second peaks (P2) of the transparent conductive films are not shown in Fig. 4. In the samples according to comparative examples 3-2, 3-4, 3-5 and 3-9 prepared at pressures of a gas mixture of Ar and O₂ of about 1.3 Pa, only second peaks (P2) are seen. In a case where a pressure of a gas mixture of Ar and O₂ is set to about 0.4 Pa, the first peaks (P1) of the transparent conductive films became smaller than the second peaks (P2) in the samples (the comparative examples 3-1 and 3-3) having the contents of WO₃ powder of about 1 percent by weight and about 3 percent by weight. Therefore, the X-ray diffraction spectrum having the first peak (P1) larger than the second peak (P2) can not be obtained. On the other hand, it has been proved that, also in a case where a pressure of a gas mixture of Ar and O₂ is set to about 0.4 Pa, when the content of WO₃ powder in the target is set to about 4 percent by weight as Example 3-5, the X-ray diffraction spectrum having the first peak (P1) on the low angle side of the transparent conductive film larger than the second peak (P2) on the high angle side can be obtained.

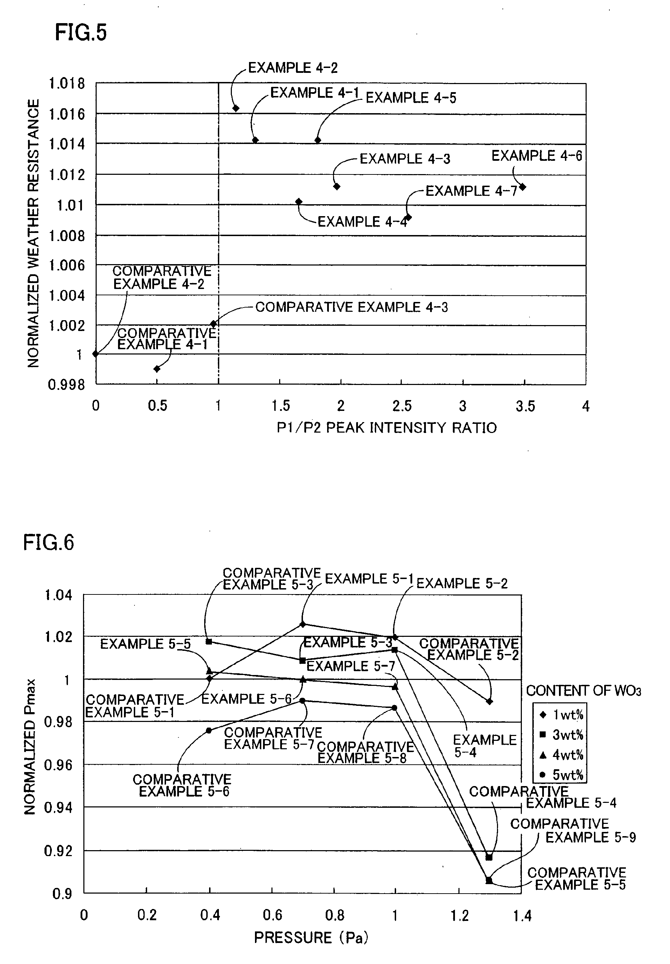

With reference to Fig. 5, results of evaluation of the relation between the intensity ratios (P1/P2) between first peaks (P1) and second peaks (P2) of transparent conductive films and normalized weather resistance of photovoltaic elements 1 will be now described. In this experiment, samples according to Examples 4-1 to 4-7 corresponding to this embodiment and samples according to comparative examples 4-1 to 4-3 were prepared.

An n-type single-crystalline silicon substrate with a surface formed thereon with a texture structure (irregular configuration) was employed for the samples according to Examples 4-1 to 4-7, and comparative example 4-1 to 4-3 dissimilarly to the samples according to the aforementioned Examples 3-1 to 3-7, comparative examples 3-1 to 3-3, and a collector and a back electrode were formed on a transparent conductive film (IWO film) formed on an upper surface of the p-type amorphous silicon layer and a lower surface of an n-type single-crystalline silicon substrate, respectively. The remaining structures of the samples (photovoltaic elements) according to Examples 4-1 to 4-7 and comparative examples 4-1 to 4-3 and processes of fabricating the IWO films were similar to those of the samples according to the aforementioned Examples 3-1 to 3-7 and comparative examples 3-1 to 3-3. Photovoltaic modules including photovoltaic elements according to Examples 4-1 to 4-7 and comparative examples 4-1 to 4-3 were prepared by employing a fabricating process similar to the photovoltaic module 10 according to the aforementioned embodiment. In the samples according to Examples 4-1 to 4-7 and comparative examples 4-1 to 4-3, acceleration tests were carried out by employing a high permeable PVF film 5 on a lower side of an EVA. The acceleration tests were carried out under a condition of a humidity of 85 % and a temperature of 85°C for 2000 hours. Cell outputs (Pmax) were measured before and after the acceleration tests, and weather resistance was calculated by dividing the cell output (Pmax) after the acceleration test by the cell output (Pmax) before the acceleration test for normalizing weather resistance. Results thereof are shown in Fig. 5. Weather resistance was normalized based on the sample according to comparative example 4-2 including only a peak having an angle 2θ (θ:X-ray diffraction angle) of 30.6 ± 0.1 degrees.

As shown in Fig. 5, it has been proved that weather resistance is improved in the samples according to Examples 4-1 to 4-7, in which the transparent conductive films consist of IWO films and the intensity ratios (P1/P2) between first peaks (P1) and second peaks (P2) of the transparent conductive films are more than 1, as compared with the samples according to comparative examples 4-1 and 4-3, in which the intensity ratios (P1/P2) between first peaks (P1) and second peaks (P2) of the transparent conductive films are less than 1, and the sample according to comparative example 4-2 having only one peak. This is conceivably for the following reason: In Examples 4-1 to 4-7, the transparent conductive film is formed on the p-type amorphous silicon layer by ion plating when forming the transparent conductive film, whereby an ion energy in forming the transparent conductive film can be reduced to about 10 eV to about 20 eV. Therefore, damage to the p-type amorphous silicon layer, the i-type amorphous silicon layer and the n-type single-crystalline silicon substrate due to ions can be reduced. Thus, reduction in weather resistance caused by the damage to the p-type amorphous silicon layer, the i-type amorphous silicon layer and the n-type single-crystalline silicon substrate due to ions can be conceivably suppressed. Additionally, in Examples 4-1 to 4-7, the transparent conductive film is formed under a condition where the rearrangement of a deposited material is facilitated like a method such as ion plating, whereby the precision of the transparent conductive film can be conceivably improved. It has been proved that there is not significant difference between the samples according to comparative examples 4-1 and 4-3, in which the intensity ratios (P1/P2) between the first peaks (P1) and the second peaks (P2) of the transparent conductive films are less than 1, and the sample according to comparative example 4-2 having one peak. The reason of this is conceivably that the precision of the transparent conductive film was not improved in the samples according to comparative examples 4-1 and 4-3, in which the intensity ratios (P1/P2) between the first peaks (P1) and the second peaks (P2) of the transparent conductive films are less than 1, dissimilarly to the samples of Examples 4-1 to 4-7, in which the intensity ratios (P1/P2) between the first peaks (P1) and the second peaks (P2) of the transparent conductive films are more than 1, although detailed mechanism is not known.

In the samples according to Examples 4-1 to 4-7 in which the intensity ratios (P1/P2) between the first peaks (P1) and the second peaks (P2) of the transparent conductive films are more than 1, normalized weather resistance was about 100.92 % to about 101.63 %. In the samples according to comparative examples 4-1 and 4-3, in which the intensity ratios (P1/P2) between the first peaks (P1) and the second peaks (P2) of the transparent conductive films are less than 1, normalized weather resistance was about 99.90 % and about 100.20 %, respectively.

With reference to Fig. 6, results of evaluation of the relation between pressures of a gas mixture of Ar and O₂, the contents of WO₃ in In₂O₃ targets and normalized cell outputs (Pmax) of the photovoltaic elements 1 will be described. In this experiment, samples according to Examples 5-1 to 5-7 corresponding to this embodiment and samples according to comparative examples 5-1 to 5-9 were prepared, and normalized cell outputs (Pmax) were measured as to the prepared samples.

An n-type single-crystalline silicon substrate with a surface formed thereon with a texture structure (irregular configuration) was employed for the samples according to Examples 5-1 to 5-7, and comparative examples 5-1 to 5-9 dissimilarly to the samples according to the aforementioned Examples 3-1 to 3-7 and comparative examples 3-1 to 3-9, and a collector and a back electrode were formed on a transparent conductive film (IWO film) formed on an upper of the p-type amorphous silicon layer and a lower surface of an n-type single-crystalline silicon substrate, respectively. The remaining structures of the samples according to Examples 5-1 to 5-7 and comparative examples 5-1 to 5-9 and processes of fabricating the IWO films were similar to those of the samples according to the aforementioned Examples 3-1 to 3-7 and comparative examples 3-1 to 3-9, respectively. Cell outputs (Pmax) were measured as to these samples and normalized. Results thereof are shown in Fig. 6. The cell outputs (Pmax) were normalized based on the cell output (Pmax) by the same normalized photovoltaic element as that used when calculating the normalized cell outputs (Pmax) of Examples 2-1 and 2-2 and comparative examples 2-1 and 2-2 shown in Fig. 3.

As shown in Fig. 6, it has been proved that the cell output (Pmax) of the photovoltaic element 1 tends to be reduced, as the content of WO₃ powder in the target is increased. This is conceivably for the following reason: The specific resistance of the transparent conductive film can be reduced as the content of WO₃ in the In₂O₃ target is increased, while W in the transparent conductive film is increased, whereby light transmittance is reduced more than the decreasing rate of the specific resistance of the transparent conductive film. In Examples 5-1 to 5-4, and comparative examples 5-1 and 5-3, in which the contents of WO₃ in the In₂O₃ targets were 1 percent by weight or 3 percent by weight under a condition where pressures of a gas mixture of Ar and O₂ were about 0.4 Pa to about 1.0 Pa, the normalized cell outputs (Pmax) thereof were 1 or more. The normalized cell outputs (Pmax) thereof were 1 or more in Examples 5-5 and 5-6 having the contents of WO₃ in the targets of 4 percent by weight, while the normalized cell outputs (Pmax) thereof was less than 1 in Example 5-7. In comparative examples 5-6 to 5-9 having the contents of WO₃ in the targets of 5 percent by weight, the normalized cell outputs (Pmax) thereof were less than 1. In comparative examples 5-2, 5-4, 5-5 and 5-9 having pressures of a gas mixture of Ar and O₂ of about 1.3 Pa when the contents of WO₃ in the In₂O₃ targets were in the range of about 1 percent by weight to about 5 percent by weight, the normalized cell outputs (Pmax) thereof were less than 1.

The intensity ratios (P1/P2) between the first peaks (P1) and the second peaks (P2) of the transparent conductive films according to the aforementioned Examples 3-1 to 3-4, having the same structure as Examples 5-1 to 5-4 in which the contents of WO₃ in the In₂O₃ targets having the normalized cell outputs (Pmax) of 1 or more were 1 percent by weight or 3 percent by weight, and fabricated by the same process as Examples 5-1 to 5-4, were 2 or less as shown in Fig. 4. From the above, in order to improve the cell output (Pmax) of the photovoltaic element 1 and weather resistance, it is conceivably desirable that the intensity ratio (P1/P2) between the first peak (P1) and the second peak (P2) of the transparent conductive film is at least 1 and not more than 2.

A description will be made of results of evaluation of the relation between the intensity ratios (P1/P2) between first peaks (P1) and second peaks (P2) of transparent conductive films consisting of ITO films dissimilarly to the transparent conductive films consisting of the IWO film shown in Figs. 2 to 6 and normalized weather resistance of the photovoltaic elements 1. In this experiment, a sample according to Example 6-1 corresponding to this embodiment was prepared and a normalized cell output (Pmax) was measured as to the prepared sample.

As the sample according to Example 6-1, a target consisting of a sintered body of In₂O₃ powder containing about 3 percent by weight of SnO₂ powder was employed for preparing a photovoltaic element 1 formed on a p-type amorphous silicon layer with a transparent conductive film (ITO film) of about 100 nm in thickness by ion plating. The remaining structures of the photovoltaic element 1 and a process of fabricating the same are similar to those of the photovoltaic element 1 according to the aforementioned embodiment. A photovoltaic module including the photovoltaic element 1 according to Example 6-1 was prepared by employing a fabricating process similar to the photovoltaic module 10 according to the aforementioned embodiment. In the sample according to Example 6-1, an acceleration test was carried out by employing a high permeable PVF film 5 on a lower side of an EVA. The acceleration test was carried out under a condition of a humidity of 85 % and a temperature of 85°C for 2000 hours. Cell outputs (Pmax) were measured before and after the acceleration test, and weather resistance was calculated by dividing the cell output (Pmax) after the acceleration test by the cell output (Pmax) before the acceleration test for normalizing weather resistance. The intensity ratio (P1/P2) between the first peak (P1) and the second peak (P2) of the transparent conductive film in the sample according to Example 6-1 was about 1.3. The normalized weather resistance of the sample according to Example 6-1 was 1.012. From these, it has been proved that the intensity ratio (P1/P2) between the first peak (P1) and the second peak (P2) of the transparent conductive film can be 1 or more by ion plating even in a case where the transparent conductive film is formed of an ITO film, and weather resistance can be improved not only in a case of the transparent conductive film consisting of an IWO film but also in a case of the transparent conductive film consisting of an ITO film.

Weather resistance was normalized by a normalized photovoltaic module in which the intensity ratio (P1/P2) of a first peak (P1) and a second peak (P2) of the transparent conductive film is about 0.5. In the normalized photovoltaic module, the transparent conductive film (ITO film) was formed by employing a target consisting of a sintered body of In₂O₃ powder containing about 5 percent by weight of SnO₂ powder by DC sputtering. Forming conditions of the transparent conductive film (ITO film) by DC sputtering were a substrate temperature of 60°C, an Ar flow rate of 200 sccm, a pressure of 0.5 Pa, DC power of 1 kW and a magnetic field of 2000 G applied to a cathode. The remaining structures of the normalized photovoltaic module and a process of fabricating the same are similar to those of the photovoltaic module according to the aforementioned Example 6-1.

It has been proved from an experiment made by the inventor that, in a photovoltaic element consisting of a thin film semiconductor, a cell output (Pmax) and weather resistance are improved by employing the transparent conductive film consisting of the IWO film, as compared with in a case of the transparent conductive film consisting of the ITO film. More specifically, in this experiment, the IWO film was formed on a metal substrate at a pressure of a gas mixture of Ar and O₂ of about 0.7 Pa by employing a target consisting of a sintered body of In₂O₃ powder containing about 3 percent by weight of WO₃ powder. An n-type microcrystalline silicon film, an i-type microcrystalline silicon film, and a p-type microcrystalline silicon film were sequentially formed on the IWO film, two of which were prepared. One of them was formed with an IWO film and a collector on the p-type microcrystalline silicon film, the other was formed with the ITO film and a collector on the p-type microcrystalline silicon film. Conditions for forming the IWO film were the content of WO₃ powder of about 3 percent by weight and a pressure of a gas mixture of Ar and O₂ of about 0.7 Pa. Conditions for forming the ITO film were similar to those of the normalized photovoltaic element used when calculating the normalized cell outputs (Pmax) of Examples 2-1 and 2-2 and comparative examples 2-1 and 2-2 shown in Fig. 3. According to result obtained by comparing the cell outputs (Pmax) and weather resistance, the cell outputs (Pmax) and weather resistance were improved in the sample employing the IWO film as compared with the sample employing the ITO film. The IWO film was formed between the metal substrate and the n-type microcrystalline silicon film, whereby the cell output (Pmax) was improved as compared with a case where the ITO film or an ZnO film is formed between the metal substrate and the n-type microcrystalline silicon film.

Although the present invention has been described and illustrated in detail, it is clearly understood that the same is by way of illustration and example only and is not to be taken by way of limitation, the spirit and scope of the present invention being limited only by the terms of the appended claims.

For example, while the above embodiment has been described with reference to the case of employing a photoelectric conversion layer consisting of the n-type single-crystalline silicon substrate, the present invention is not restricted to this but similar effects can be attained also when employing a photoelectric conversion layer consisting of a p-type single-crystalline silicon substrate or an amorphous silicon layer.

While the present invention is applied to the photovoltaic element having the transparent conductive film and a structure in which the i-type amorphous silicon layer and the p-type amorphous silicon layer are formed on the n-type single-crystalline silicon substrate in the aforementioned embodiment, the present invention is not restricted to this but similar effects can be attained also when employing a photovoltaic element not having the aforementioned structure as long as having the transparent conductive film.

While the above embodiment has been described with reference to the case of forming the transparent conductive film on the amorphous silicon layer, the present invention is not restricted to this but similar effects can be attained also when forming the transparent conductive film according to the present invention on a microcrystalline silicon layer, an amorphous SiC layer or an amorphous SiO layer

While the indium oxide (IWO or ITO) film doped with W or Sn is employed as the material for constituting the transparent conductive film in the aforementioned embodiment, the present invention is not restricted to this but the transparent conductive film may alternatively consist of a material prepared from indium oxide doped with a material other than W or Sn. For example, the transparent conductive film may alternatively be doped with at least one of Ti, Zn, Ta and Re or combination of two or more of Ti, Zn, Ta and Re. For example, at least one of Ti, Sn and Zn may be doped in the transparent conductive film in addition to W.

While an ion energy in forming the transparent conductive film is reduced to about 10 eV to about 20 eV by ion plating for forming the transparent conductive film consisting of the indium oxide film in the aforementioned embodiment, the present invention is not restricted to this but the transparent conductive film consisting of the indium oxide film having the first peak (P1) on the low angle side and the second peak (P2) on the high angle side having the peak intensity level lower than the first peak (P1) may alternatively formed by a method other than ion plating, in which an ion energy in forming the transparent conductive film can be reduced to about 100 eV or less. For example, also when employing sputtering performed by RF sputtering on DC sputtering while applying a strong magnetic field, pulse modulation DC discharge, RF discharge, VHF discharge, microwave discharge, ion beam deposition or the like, and setting a forming condition where an ion energy in forming the transparent conductive film can be reduced to about 100 eV or less, the transparent conductive film consisting of the indium oxide film having the first peak (P1) on the low angle side and the second peak (P2) on the high angle side having the peak intensity level lower than the first peak (P1) can be formed. In this case, when the transparent conductive film consisting of the indium oxide layer including (222) peak having two peaks is formed, effects similar to those of the present invention can be attained. It has been confirmed that, when employing sputtering performed by RF sputtering on DC sputtering while applying a strong magnetic field, the transparent conductive film is formed under a condition of a magnetic field of about 3000 G, DC power of 1.2 kW and RF power of 0.6 kW, whereby an ion energy in forming the transparent conductive film can be reduced to about 100 eV or less, and plasma damage to the semiconductor layer serving as an underlayer for the transparent conductive film can be suppressed. When employing sputtering performed by RF sputtering on DC sputtering while applying a strong magnetic field, pulse modulation DC discharge, RF discharge, VHF discharge, or microwave discharge, it is desirable that the transparent conductive film is formed at about 150°C to about 200°C in order to facilitate the rearrangement of a deposited material (IWO or ITO). When employing ion beam deposition, heating in forming a film may not be performed in a similar manner to the aforementioned embodiment employing ion plating.

While the present invention is applied to the photovoltaic element formed with the i-type amorphous silicon layer and the p-type amorphous silicon layer only on the front surface of the n-type single-crystalline silicon substrate in the aforementioned embodiment, the present invention is not restricted to this but similar effects can be attained also when the present invention is applied to a photovoltaic element formed with the i-type amorphous silicon layer and the p-type amorphous silicon layer on the front surface of the n-type single-crystalline silicon substrate and formed with the i-type amorphous silicon layer and the n-type amorphous silicon layer on the back surface of the n-type single-crystalline silicon substrate. In this case, an i-type amorphous silicon layer having a thickness of about 5nm and an n-type amorphous silicon layer having a thickness of about 5nm are formed on the lower surface (back surface) of the n-type single-crystalline silicon substrate in this order. Compound gas containing at least one of a group V element such as P, N, As or Sb can be alternatively employed for forming the n-type amorphous silicon layer.

While Ar gas is employed when forming the indium oxide layer constituting the transparent conductive film in the aforementioned embodiment, the present invention is not restricted to this but another inert gas such as He, Ne, Kr or Xe or a gas mixture thereof can be alternatively employed.

While the i-type amorphous silicon layer and the p-type amorphous silicon layer are formed by RF plasma CVD in the aforementioned embodiment, the present invention is not restricted to this but the amorphous silicon layers may alternatively be formed by another method such as evaporation, sputtering, microwave plasma CVD, ECR, thermal CVD or LPCVD (low-pressure CVD).

While the aforementioned embodiment employs silicon (Si) as a semiconductor material, the present invention is not restricted to this but any semiconductor material selected from SiGe, SiGeC, SiC, SiN, SiGeN, SiSn, SiSnN, SiSnO, SiO, Ge, GeC and GeN may alternatively be employed. In this case, the selected semiconductor material may be a crystalline material or an amorphous or microcrystalline material containing at least either hydrogen or fluorine.

While one p-i-n structure is formed in the photovoltaic element in the aforementioned embodiment, the present invention is not restricted to this but a plurality of p-i-n structures are formed in the photovoltaic element by stack.

## Claims

1. A photovoltaic element comprising:
a photoelectric conversion layer (1a); and
a transparent conductive film (1b) formed on a surface of said photoelectric conversion layer (1a) and including an indium oxide layer having (222) orientation and two X-ray diffraction peaks, wherein
said two X-ray diffraction peaks of said indium oxide layer are constituted by a first peak on a low angle side and a second peak on a high angle side having a peak intensity level lower than said first peak.

2. The photovoltaic element according to claim 1, wherein
said first peak on said low angle side of said indium oxide layer has an angle 2θ (θ:X-ray diffraction angle) in the vicinity of 30.1 degrees, and
said second peak on said high angle side of said indium oxide layer has an angle 2θ (θ:X-ray diffraction angle) in the vicinity of 30.6 degrees.

3. The photovoltaic element according to claim 1, wherein
the intensity ratio between said first peak and said second peak of said indium oxide layer is at least 1.

4. The photovoltaic element according to claim 3, wherein,
the intensity ratio between said first peak and said second peak of said indium oxide layer is at most 2.

5. The photovoltaic element according to claim 1, wherein
said indium oxide layer includes W.

6. The photovoltaic element according to claim 1, wherein
said indium oxide layer includes Sn.

7. The photovoltaic element according to claim 1, further comprising:
a semiconductor layer formed thereon with said transparent conductive film (1b) and consisting of at least either an amorphous semiconductor or a microcrystalline semiconductor; and
a collector (1c) formed on said transparent conductive film (1b).

8. The photovoltaic element according to claim 7, wherein
said semiconductor layer includes an amorphous silicon layer.

9. A photovoltaic module comprising:
a photoelectric conversion layer (1a);
a plurality of photovoltaic elements, each of which including a transparent conductive film (1b) formed on a surface of said photoelectric conversion layer and including an indium oxide layer having (222) orientation and two X-ray diffraction peaks;
a transparent surface protector (4) arranged on surfaces of said transparent conductive films (1b) of said plurality of photovoltaic elements; and
a resin film (5) so arranged as to hold said plurality of photovoltaic elements between said surface protector (4) and said resin film (5), wherein
said two X-ray diffraction peaks of said indium oxide layer of said photovoltaic element are constituted by a first peak on a low angle side and a second peak on a high angle side having a peak intensity level lower than said first peak.

10. The photovoltaic module according to claim 9, wherein
said first peak on said low angle side of said indium oxide layer has an angle 2θ (θ: X-ray diffraction angle) in the vicinity of 30.1 degrees, and
said second peak on said high angle side of said indium oxide layer has an angle 2θ (θ : X-ray diffraction angle) in the vicinity of 30.6 degrees.

11. The photovoltaic module according to claim 9, wherein
the intensity ratio between said first peak and said second peak of said indium oxide layer is at least 1.

12. The photovoltaic module according to claim 11, wherein
the intensity ratio between said first peak and said second peak of said indium oxide layer is at most 2.

13. The photovoltaic module according to claim 9, wherein
said indium oxide layer includes W.

14. The photovoltaic module according to claim 9, wherein
said indium oxide layer includes Sn.

15. The photovoltaic module according to claim 9, further comprising:
a semiconductor layer formed thereon with said transparent conductive film (1b) and consisting of at least either an amorphous semiconductor or a microcrystalline semiconductor; and
a collector (1c) formed on said transparent conductive film (1b).

16. The photovoltaic module according to claim 9, wherein
said semiconductor layer includes an amorphous silicon layer.

17. A method of fabricating a photovoltaic element, comprising steps of:
forming a photoelectric conversion layer (1a); and
forming a transparent conductive film (1b) including an indium oxide layer having (222) orientation and two X-ray diffraction peaks on a surface of said photoelectric conversion layer (1a) by ion plating, wherein
said two X-ray diffraction peaks of said indium oxide layer are constituted by a first peak on a low angle side and a second peak on a high angle side having a peak intensity level lower than said first peak.

18. The method of fabricating a photovoltaic element according to claim 17, wherein
said step of forming said transparent conductive film (1b) includes a step of forming said transparent conductive film (1b) by ion plating under a condition of an ion energy of at least 10 eV and not more than 20 eV.

19. The method of fabricating a photovoltaic element ) according to claim 17, wherein
said step of forming said transparent conductive film (1b) includes a step of forming said transparent conductive film (1b) by ion plating under a condition where the content of WO₃ powder in a target is at least 1 percent by weight and not more than 3 percent by weight and a pressure of a gas mixture of Ar and O₂ is at least 0.7 Pa and not more than 1.0 Pa.

20. The method of fabricating a photovoltaic element according to claim 17, wherein
said step of forming said transparent conductive film (1b) includes a step of forming said transparent conductive film (1b) prepared from a target containing SnO₂ powder by ion plating under a condition where a pressure of a gas mixture of Ar and O₂ is at least 0.4 Pa and not more than 1.0 Pa.
